# EUROPEAN PATENT APPLICATION

(11) **EP 2 434 306 A1**
(43) Date of publication of application: **28.03.2012**
(21) Application number: 11182602.0
(22) Date of filing: 23.09.2011
(51) Int. Cl.: G01R 33/30

(54) **Microwells with MRI readable indicia**

(30) Priority: 27.09.2010 US 386632 P
(71) Applicant: Aspect Magnet Technologies Ltd., Shoham 60850 (IL)
(72) Inventor: Rapoport, Uri, 73115 Moshav Ben Shemen (IL)
(74) Representative: Loichen, Martin

(57) **Abstract**

The present invention is directed to a microwell array comprising a plurality of **MRI-**readable indicia which may serve for identification or determining the location of a well. Moreover, the present invention is directed to a method of indicating well identification or location in an **MRI-**analyzed reaction or medium thereof, comprising providing a microwell or a microwell accessory with a plurality of **MRI-**readable indicia and MRI-analyzing the same.

## Description

### FIELD OF THE INVENTION

The present invention generally pertains to microwells with **MRI** readable indicia and to methods using the same.

### BACKGROUND OF THE INVENTION

Microtiter plate or microplate or microwells (herein after: 'microwell') is a flat plate with multiple "wells" used as small test tubes. The microplate has become a standard tool in analytical research and clinical diagnostic testing laboratories. A very common usage is in the enzyme-linked immunosorbent assay (ELISA), the basis of most modern medical diagnostic testing in humans and animals.

A microplate typically has **6, 12, 24, 96, 384** or even **1536** sample wells arranged in a 2:3 rectangular matrix. Some microplates have even been manufactured with **3456** or even **9600** wells, and an "array tape" product has been developed that provides a continuous strip of microplates embossed on a flexible plastic tape.

Each well of a microplate typically holds somewhere between tens of nanolitres to several millilitres of liquid. They can also be used to store dry powder or as racks to support glass tube inserts. Wells can be either circular or square. For compound storage applications, square wells with close fitting silicone cap-mats are preferred. Microplates can be stored at low temperatures for long periods, may be heated to increase the rate of solvent evaporation from their wells and can even be heat-sealed with foil or clear film.

Microplates with an embedded layer of filter material were developed in the early 1990s by several companies, and in **1992**, the world's first Solid Phase Extraction (SPE) microplate was launched by Porvair Sciences. This allowed simple column chromatography to be carried out in a microplate footprint for the first time. Today there are microplates for just about every application in life Science research which involves filtration, separation, optical detection, storage, reaction mixing or cell culture.

The enormous growth in studies of whole live cells has led to an entirely new range of microplate products which are "tissue culture treated" especially for this work. The surfaces of these products are modified using a plasma discharge to make them easier for adherent cells to grow on.

A number of companies have developed robots to specifically handle SBS microplates. These robots may be liquid handlers which aspirate or dispense liquid samples from and to these plates, or "plate movers" which transport them between instruments, plate stackers which store microplates during these processes, plate hotels for longer term storage or microplate incubators to ensure constant temperature during testing.

Instrument companies have designed plate readers which can detect specific biological, chemical or physical events in samples stored in these plates.

It was recently disclosed that **MRI** is an effective analysis instrument for studying reactions provided in micro scale, namely in microplates, see e.g., Directed evolution of a magnetic resonance imaging contrast agent for noninvasive imaging of dopamine by Mikhail G Shapiro et al., Nature Biotechnology, 28,264-270(2010**)**.

A few patents pertain to **MRI** and microplates. Hence for example, US patent application 2001/0024796discloses a method of screening a plurality of samples for a selected property, the method comprising: (i) providing an artificially generated physical array, which physical array comprises one or more samples at each of a plurality of spatial locations; (ii) placing the physical array in a magnetic field or applying a magnetic field to the physical array; (iii) performing magnetic resonance imaging spectroscopy (MRI) on the one or more samples of the physical array, thereby identifying the spatial location for each of the one or more samples having one or more **MRI** detectable chemical shifts, which one or more chemical shifts correspond to the selected property, thereby screening the plurality of samples for the selected property. The application also discloses an apparatus for screening a plurality of samples, the apparatus comprising: (i) a magnetic resonance imaging spectrometer; and, (ii) at least one microwell plate or other artificially generated physical array, wherein during operation of the apparatus the at least one microwell plate or other artificially generated physical array is positioned within a magnetic field produced by the magnetic resonance imaging spectrometer.

Moreover, various patents discloses means and method for providing indicia in **MRI** diagnostic. Hence for example, US patent 6957098 discloses a method for locating a catheter, the method comprising: providing a pressure sensitive device attached to a body of a catheter; providing a circuit coupled to the pressure sensitive device in the catheter, generating a magnetic field, the magnetic field inducing and causing the circuit to oscillate; applying a pressure on the pressure sensitive device, the pressure applied on the pressure sensitive device changing an oscillating frequency of the circuit; detecting oscillation of the circuit; and determining location of the catheter based on the oscillation of the circuit.

None of the above provides a simple solution for precise and simple identification of tested microwell provided online, in situ within an **MRI** device. Hence **MRI-**readable microwell indicia fulfills a long felt need.

### SUMMARY OF THE INVENTION

It is thus one object of the invention to disclose a microwell comprising a plurality of **MRI-**readable indicia. It is in the scope of the invention wherein said indicia indicate the identification or location of at least one predefined well or a plurality of wells. It is also in the scope of the invention wherein said indicia is selected from a mark, figure, number, text, code, barcode, readable texture or indication thereof.

It is another object of the invention to disclose a microwell accessory comprising a plurality of **MRI**-readable indicia. It is in the scope of the invention wherein said indicia indicate the identification or location of a predefined well. It is also in the scope of the invention wherein said indicia is selected from a mark, figure, number, text, code, barcode, readable texture or indication thereof.

It is another object of the invention to disclose a method of indicating well identification or location in an **MRI**-analyzed reaction or medium thereof, comprising providing a microwell with a plurality of **MRI**-readable indicia and MRI-analyzing the same. It is in the scope of the invention wherein said indicia indicate the identification or location of predefined well. It is also in the scope of the invention wherein said indicia is selected from a mark, figure, number, text, code, barcode, readable texture or indication thereof.

### BRIEF DESCRIPTION OF THE DRAWINGS

Fig. I is a schematic illustration of an exemplary embodiment of the present invention;
Fig. 2 is a schematic illustration of an exemplary embodiment of the present invention; and
Fig. 3 is a schematic illustration of an exemplary embodiment of the present invention.

### DETAILED DESCRIPTION OF THE PREFERRED EMBODIMENTS

The following description is provided, alongside all chapters of the present invention, to enable any person skilled in the art to make use of the invention and sets forth the best modes contemplated by the inventor of carrying out this invention. Various modifications, however, will remain apparent to those skilled in the art, since the generic principles of the present invention have been defined specifically to provide microwells with **MRI** readable indicia and to methods using the same.

The term **'Magnetic Resonance Device' (MRD)** specifically applies hereinafter to any Magnetic Resonance Imaging **(MRI)** device, any Nuclear Magnetic Resonance **(NMR)** spectroscope, any Electron Spin Resonance **(ESR)** spectroscope, any Nuclear Quadruple Resonance **(NQR)** spectroscope or any combination thereof. The **MRD** hereby disclosed is optionally a portable **MRI** device, such as the **ASPECT** Magnet Technologies Ltd commercially available devices, or a commercially available non-portable device. Moreover, the term **'MRD'** generally refers in this patent to any medical device, at least temporary accommodating an anesthetized animal.

The term **'microwell'** refers to microtiter plate or microplate or microwells or microwell array used in laboratory.

The term **'microwell** accessory' refers microwell cover, lid, base, stand, or any accessory or appendix known in the art.

As used herein, the term **"plurality"** refers in a non-limiting manner to any integer equal or greater than I.

The term **'about'** refers herein to a value of ± 25% of the defined measure.

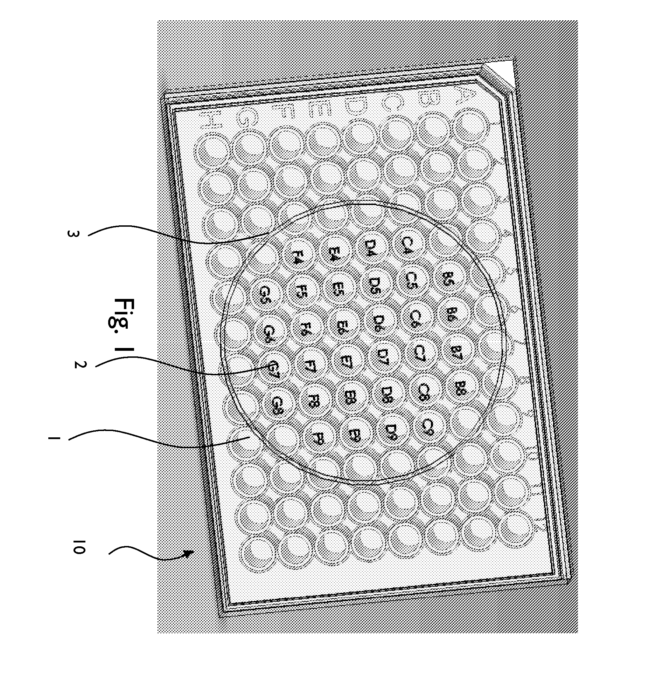

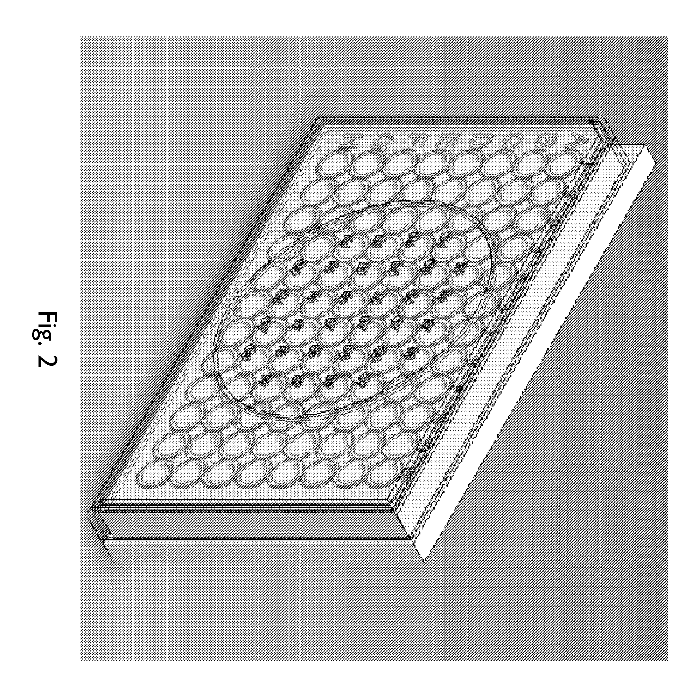

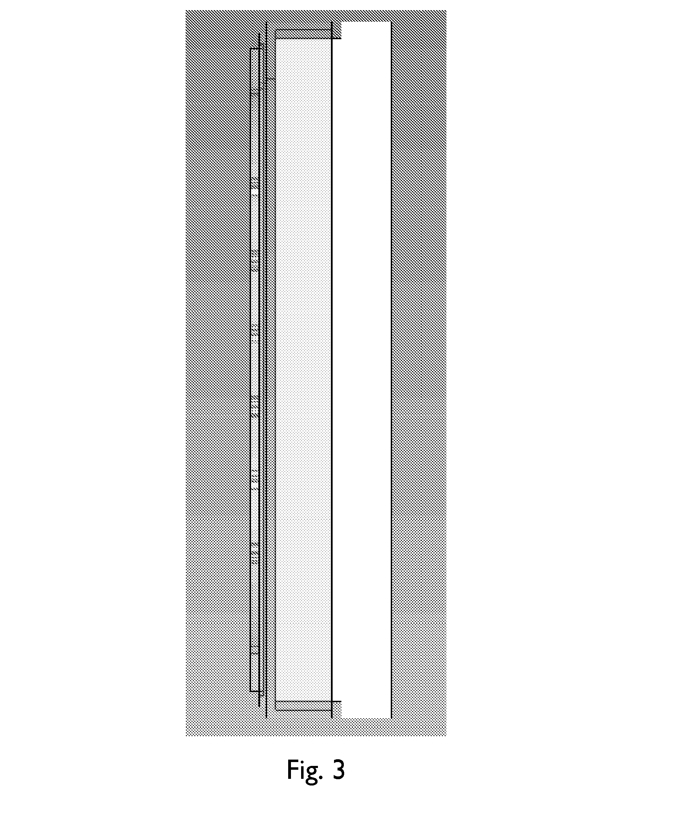

Reference is made to **Fig. 1-3** schematically illustrating (not to scale) various views of a microwell 10 according one embodiment of the invention, comprising a plurality of wells I, and a [plurality of **MRI-**readable indicia, here for example numbers indication well location in the array 2 and **MRI-**effective field 3, a location where the best **MRI** resolution is apparent.

According to yet another embodiment of the invention, the indicia is provided not on the microwell, yet on or within the microwell accessory, such as on the microwell base or disposable lid or multiuse cover etc.

It is well within the scope of the invention wherein indicia are all indicators and material readable by means of **MRI, NMR** and **CT** devices, and/or by means of other analysis devices, such as optical instruments.

According to yet another embodiment of the invention, the indicia is provided within a plurality of all the wells in the microwell.

According to yet another embodiment of the invention, the indicia is provided remotely or adjacent to a plurality or all the wells in the microwell.

According to yet another embodiment of the invention, the indicia is temporarily provided, e.g., by providing a plurality of channels were flowing indicia (water or the like) is provided in just before **MRI** analysis.

According to yet another embodiment of the invention, the indicia is permanently provided, e.g., by molding the indicia within the microiwells.

According to yet another embodiment of the invention, the indicia is time-resolved, reaction-resolved or composition-resolved.

## Claims

1. A microwell array comprising a plurality of **MRI-**readable indicia.

2. The microwell array of claim I, wherein said indicia indicate the identification or location of at least one predefined well.

3. The microwell array of claim I, wherein said indicia indicate the identification or location of a plurality of predefined wells.

4. The microwell array of claim I, wherein said indicia is selected from the group consisting o a mark, figure, number, text, code, barcode, readable texture or indication thereof.

5. A microwell accessory comprising a plurality of **MRI-**readable indicia.

6. The microwell accessory of claim 5, wherein said indicia indicate the identification or location of predefined wells.

7. The microwell array of claim 5, wherein said indicia is selected from the group consisting of a mark, figure, number, text, code, barcode, readable texture or indication thereof.

8. A method of indicating well identification or location in an MRI-analyzed reaction or medium thereof, comprising providing a microwell with a plurality of MRI-readable indicia and MRI-analyzing the same.

9. A method of indicating well identification or location in an MRI-analyzed reaction or medium thereof, comprising providing a microwell accessory with a plurality of MRI-readable indicia and **MRI**-analyzing the same.

10. The method of claim 9, wherein said indicia is selected from the group consisting of a mark, figure, number, text, code, barcode, readable texture or indication thereof.
